# EUROPEAN PATENT APPLICATION

(11) **EP 4 340 317 A1**
(43) Date of publication of application: **20.03.2024**
(21) Application number: 21941191.5
(22) Date of filing: 10.05.2021
(51) Int. Cl.: H04L 45/00

(54) **DATA PACKET TRANSMISSION METHOD, DATA PACKET TRANSMISSION APPARATUS, AND STORAGE MEDIUM**

(71) Applicant: Beijing Xiaomi Mobile Software Co., Ltd., Beijing 100085 (CN)
(72) Inventor: CHEN, Dong, Beijing 100085 (CN)
(74) Representative: Gunzelmann, Rainer
(86) International application number: PCT/CN2021/092864
(87) International publication number: WO 2022/236615

(57) **Abstract**

Provided are a data packet transmission method, a data packet transmission apparatus, and a storage medium. The data packet transmission method is applied to a first device, and the method comprises: sending an Internet protocol (IP) data packet (S11); the IP data packet comprising: a router identifier for transmitting the IP data packet, and a time range corresponding to the router identifier; the time range being a range corresponding to the time of processing the IP data packet by a router identified by the router identifier. Thus, the capability of the router for processing a data packet can be reduced.

## Description

### FIELD

The present disclosure relates to the field of wireless communication technology, and more particularly to a method for transmitting a data packet, an apparatus and a device for transmitting a data packet, and a storage medium.

### BACKGROUND

Internet protocol (IP) is a protocol for transmitting information among networks. An IP data packet (also called an IP information packet) may be transmitted from a source device (also called a transmitting device) to a destination device (also called a receiving device). In a process for transmitting the IP data packet from the source device to the destination device, the IP data packet is generally transmitted according to an IP address of the destination device and a network transmission mechanism of a router.

In the related art, various networks are connected to each other through routers. A function of the router is to select a transmission path for the IP data packet. The source device transmits the IP data packet, and the router for transmitting the IP data packet is determined by the source device. That is, the source device completely knows every router through which the IP data packet passes, and specifies a time for each router to transmit the IP data packet, thereby ensuring a precise time for the IP data packet to reach the destination device. However, one router may need to transmit multiple IP data packets at the same time, which requires the router to have a high processing capability. In this case, if the capability of the router to process the IP data packet is not high enough to support transmitting the multiple IP data packets at the same time, an arrival time of the IP data packet at the destination device may not be guaranteed.

### SUMMARY

In order to solve the problems in the related art, the present disclosure provide a method for transmitting a data packet, an apparatus and a device for transmitting a data packet, and a storage medium.

According to a first aspect of embodiments of the present disclosure, there is provided a method for transmitting a data packet, applied to a first device, including: transmitting an Internet protocol (IP) data packet. The IP data packet includes: an identifier of a router for transmitting the IP data packet, and a time range corresponding to the identifier of the router. The time range is a range corresponding to a time at which the router identified by the identifier of the router processes the IP data packet.

In one embodiment, a first time is a processing time for the router to process the IP data packet, and a second time is a time error that is allowable for the router to process the IP data packet; or the first time is a minimum time allowing the router to process the IP data packet, and the second time is a maximum time allowing the router to process the IP data packet.

In one embodiment, the identifier of the router is a router address.

In one embodiment, a plurality of identifiers of routers exist and are included in a routing flow table. The method for transmitting the data packet further includes: transmitting the IP data packet according to the router address included in the routing flow table.

In one embodiment, the IP data packet further includes hop count information, and the hop count information includes a hop count. The hop count is a total hop count of routers identified by the identifiers of the routers and a hop count between a router corresponding to a last router address with respect to a destination IP address and the destination IP address where the IP data packet is transmitted to.

According to a second aspect of embodiments of the present disclosure, there is provided a method for transmitting a data packet, applied to a second device, including: receiving an Internet protocol (IP) data packet. The IP data packet includes: an identifier of a router for transmitting the IP data packet, and a first time and a second time corresponding to the identifier of the router. The first time and the second time determine a processing time range corresponding to a time at which the router identified by the identifier of the router processes the IP data packet; and determining, according to the IP data packet, the processing time range corresponding to the time for processing the IP data packet.

In one embodiment, the first time is a processing time for the router to process the IP data packet, and the second time is a time error that is allowable for the router to process the IP data packet; or the first time is a minimum time allowing the router to process the IP data packet, and the second time is a maximum time allowing the router to process the IP data packet.

In one embodiment, the identifier of the router is a router address.

In one embodiment, a plurality of identifiers of routers exist and are included in a routing flow table. The method for transmitting the data packet further includes: transmitting the IP data packet according to the router address included in the routing flow table.

In one embodiment, the IP data packet further includes hop count information, and the hop count information includes a hop count. The hop count is a total hop count of routers identified by the identifiers of the routers and a hop count between a router corresponding to a last router address with respect to a destination IP address and the destination IP address where the IP data packet is transmitted to.

According to a third aspect of embodiments of the present disclosure, there is provided an apparatus for transmitting a data packet, applied to a first device, including: a transmitting module configured to transmit an Internet protocol (IP) data packet. The IP data packet includes: an identifier of a router for transmitting the IP data packet, and a first time and a second time corresponding to the identifier of the router. The first time and the second time determine a processing time range corresponding to a time at which the router identified by the identifier of the router processes the IP data packet.

In one embodiment, the first time is a processing time for the router to process the IP data packet, and the second time is a time error that is allowable for the router to process the IP data packet; or the first time is a minimum time allowing the router to process the IP data packet, and the second time is a maximum time allowing the router to process the IP data packet.

In one embodiment, the identifier of the router is a router address.

In one embodiment, a plurality of identifiers of routers exist and are included in a routing flow table. The transmitting module is further configured to: transmit the IP data packet according to the router address included in the routing flow table.

In one embodiment, the IP data packet further includes hop count information, and the hop count information includes a hop count. The hop count is a total hop count of routers identified by the identifiers of the routers and a hop count between a router corresponding to a last router address with respect to a destination IP address and the destination IP address where the IP data packet is transmitted to.

According to a fourth aspect of embodiments of the present disclosure, there is provided an apparatus for transmitting a data packet, applied to a second device, including: a receiving module configured to receive an Internet protocol (IP) data packet, and determine, according to the IP data packet, the processing time range corresponding to the time for processing the IP data packet. The IP data packet includes: an identifier of a router for transmitting the IP data packet, and a first time and a second time corresponding to the identifier of the router. The first time and the second time determine a processing time range corresponding to a time at which the router identified by the identifier of the router processes the IP data packet.

In one embodiment, the first time is a processing time for the router to process the IP data packet, and the second time is a time error that is allowable for the router to process the IP data packet; or the first time is a minimum time allowing the router to process the IP data packet, and the second time is a maximum time allowing the router to process the IP data packet.

In one embodiment, the identifier of the router is a router address.

In one embodiment, a plurality of identifiers of routers exist and are included in a routing flow table. The apparatus for transmitting the data packet further includes: a transmitting module configured to transmit the IP data packet according to the router address included in the routing flow table.

In one embodiment, the IP data packet further includes hop count information, and the hop count information includes a hop count. The hop count is a total hop count of routers identified by the identifiers of the routers and a hop count between a router corresponding to a last router address with respect to a destination IP address and the destination IP address where the IP data packet is transmitted to.

According to a fifth aspect of embodiments of the present disclosure, there is provided a device for transmitting a data packet, including: a processor; and a memory for storing processor-executable instructions; the processor is configured to perform the method for transmitting the data packet according to the first aspect or any one of embodiments of the first aspect, or perform the method for transmitting the data packet according to the second aspect or any one of embodiments of the second aspect.

According to a sixth aspect of embodiments of the present disclosure, there is provided a non-transitory computer readable storage medium having instructions that, when executed by a processor of a mobile terminal, cause the mobile terminal to perform the method for transmitting the data packet according to the first aspect or any one of embodiments of the first aspect, or perform the method for transmitting the data packet according to the second aspect or any one of embodiments of the second aspect.

The technical solutions provided by embodiments of the present disclosure may include the following advantages: with the present disclosure, the time error allowable for processing the IP data packet is introduced for the router for transmitting the IP data packet, so that the router may process the IP data packet and transmit the IP data packet in the range of the processing time plus the time error allowable for processing the IP data packet, thereby reducing the requirement on the capacity of the router for processing the data packet.

It is to be understood that both the foregoing general description and the following detailed description are explanatory only, and shall not be construed to limit the present disclosure.

### BRIEF DESCRIPTION OF THE DRAWINGS

The accompanying drawings, which are incorporated in and constitute a part of this specification, illustrate embodiments in line with the present disclosure and, together with the description, serve to explain the principle of the present disclosure.
FIG. 1 is a schematic diagram illustrating a system architecture for transmitting an IP data packet according to an embodiment.
FIG. 2 is a schematic diagram illustrating a format of an IP data packet according to an embodiment.
FIG. 3 is a flow chart of a method for transmitting a data packet according to an embodiment.
FIG. 4 is a flow chart of another method for transmitting a data packet according to an embodiment.
FIG. 5 is a flow chart of yet another method for transmitting a data packet according to an embodiment.
FIG. 6 is a flow chart of a further method for transmitting a data packet according to an embodiment.
FIG. 7 is a block diagram illustrating an apparatus for transmitting a data packet according to an embodiment.
FIG. 8 is a block diagram illustrating another apparatus for transmitting a data packet according to an embodiment.
FIG. 9 is a block diagram illustrating a device for transmitting a data packet according to an embodiment.
FIG. 10 is a block diagram illustrating another device for transmitting a data packet according to an embodiment.

### DETAILED DESCRIPTION

Reference will now be made in detail to embodiments, examples of which are illustrated in the accompanying drawings. The following description refers to the accompanying drawings in which the same numbers in different drawings represent the same or similar elements unless otherwise represented. The implementations set forth in the following description of embodiments do not represent all implementations consistent with the present disclosure. Instead, they are merely examples of apparatuses and methods consistent with aspects related to the present disclosure as recited in the appended claims.

In communication technology, Internet protocol (IP) is a protocol for transmitting information among networks, and an IP data packet may be transmitted from a source device to a destination device. In a process for transmitting the IP data packet from the source device to the destination device, the IP data packet is generally transmitted according to an IP address of the destination device and a network transmission mechanism of a router.

On one hand, all devices (e.g., the source and destination devices described above) over the Internet should have a unique IP address. In other words, there is a one-to-one correspondence between the IP address and the device. The IP data packet should contain the IP address of the destination device, and the data packet is transmitted to the destination device according to the IP address in the data packet. A device on the Internet network may have multiple IP addresses, but it should have at least one unique IP address.

On the other hand, the Internet is a large network formed by connecting many networks. When the IP data packet is transmitted over the Internet, the network transmission mechanism of the router is required in addition to the IP address of the destination device described above. The IP data packet may be transmitted to the destination device through multiple routers via the network transmission mechanism of the router. The network transmission mechanism of the router may also be referred to as an IP routing transmission mechanism.

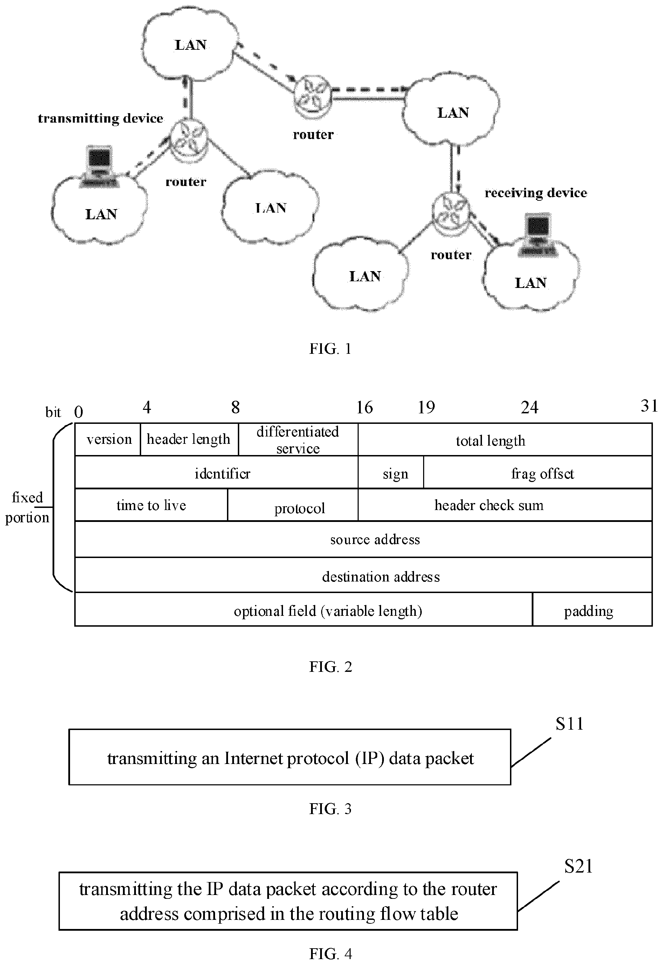

FIG. 1 is a schematic diagram illustrating a system architecture for transmitting an IP data packet according to an embodiment. The method provided by the present disclosure may be applied to the system architecture shown in FIG. 1. As shown in FIG. 1, the source device (i.e. a source computer in FIG. 1) may transmit the IP data packet according to the architecture shown in FIG. 1, and transmit the IP data packet to the destination device (i. e. a destination computer in FIG. 1) through the multiple routers.

FIG. 2 is a schematic diagram illustrating a format of an IP data packet according to an embodiment. In the related art, the IP data packet contains a source address and a destination address in the format shown in FIG. 2, including a fixed part and an optional field with variable length. The fixed part includes a version, a header length, a differentiated service, a total length, an identifier, a flag, a slice offset, a lifetime, a protocol, a header checksum, the source address and the destination address.

It may be seen therefrom that after the IP data packet is transmitted by the source device, the IP data packet is transmitted by the router during the process for transmitting the IP data packet. For the source device, a transmission path of the IP data packet is unknown, and a processing time at which the IP data packet is processed on each router may not be determined. Therefore, the source device does not determine a time at which the IP data packet arrives at the destination device after the IP data packet is transmitted.

Accordingly, it is proposed in the related art that the source device determines the router(s) through which the IP data packet passes, and determines a relative time (e.g., a specific moment) for each router to process the IP data packet, thereby determining a time for each router to transmit the IP data packet.

For example, the IP data packet includes an IP address of the source device, an IP address of the destination device, an identifier of a router for transmitting the IP data packet, and a processing time corresponding to the identifier of the router. The identifier of the router for transmitting the IP data packet may be arranged in the IP data packet in a form of a routing flow table. Addresses of multiple routers for transmitting the IP data packet are included in the routing flow table. As mentioned above, each router address corresponds to a processing time. For example, in a case that the routing flow table includes addresses of N routers for transmitting the IP data packet, each of the N router addresses corresponds to a processing time. A router address A corresponds to a first time A; a router address B corresponds to a first time B; ...... ; and the router address N corresponds to a processing time N.

In embodiments of the present disclosure, the IP data packet is sent out from the source device and transmitted according to an order of the router addresses in the routing flow table. In one embodiment, the router address B is taken as an example. In response to the router with the router address B receiving the IP data packet, the processing time B corresponding to the router address B in the IP data packet and a next router address C are determined. The router with the router address B, after processing the IP data packet, transmits, at the processing time B, the IP data packet to a next hop (i.e. a next router with an address C) in line with the routing flow table. In this way, the IP data packet is transmitted to the destination address.

However, in the related art, it is necessary to transmit the IP data packet at a specific time defined in the data packet according to the time requirement, and thus the router is required to have a high capacity. Generally, the router will process many data packets from different devices with different source addresses in parallel, and these data packets are further transmitted to different devices with different destination addresses. This may be a significant challenge to a parallel processing capability of the router since the router needs to transmit multiple data packets at the same time.

Accordingly, the present disclosure provides a method for transmitting the data packet. A time error for processing the IP data packet is introduced for transmitting the IP data packet, to make the router transmit the IP data packet within a time duration in a range of the time error with respect to the processing time, thereby reducing the burden on the router for processing the data packet, and still allowing the IP data packet to arrive at the destination device in the precise time.

It may be understood that the diagram of the system architecture for transmitting the IP data packet shown in FIG. 1 is only for schematic illustration. The wireless communication system may further include other network devices, such as core network devices, wireless relay devices, and wireless backhaul devices, which are not shown in FIG 1. The number of network devices and the number of terminals included in the wireless communication system are not limited in embodiments of the present disclosure.

It may be further understood that the wireless communication system in the embodiments of the present disclosure is a network that provides a wireless communication function. The wireless communication system may employ different communication technologies, such as code division multiple access (CDMA), wideband code division multiple access (WCDMA), time division multiple access (TDMA), frequency division multiple access (FDMA), orthogonal frequency-division multiple access (OFDMA), single carrier frequency division multiple access (SC-FDMA), and carrier sense multiple access with collision avoidance. The network may be classified into a 2nd generation (2G) network, a 3G network, a 4G network, or a future evolution network, such as a 5G network, which may also be referred to as a new radio (NR) network, according to capacity, rate, delay and other factors of different networks. For ease of description, a wireless communication network will be sometimes abbreviated as a network in the present disclosure.

Further, the network device involved in the present disclosure may also be referred to as a radio access network device. The radio access network device may be a base station, an evolved node B, a home base station, an access point (AP) in a wireless fidelity (WIFI) system, a wireless relay node, a wireless backhaul node, a transmission point (TP), a transmission and reception point (TRP), or may be a gNB in the NR system, or may be a component or a part of a device that constitutes a base station. The network device may also be a vehicle-mounted device when it is used in a vehicle to everything (V2X) communication system. It is to be understood that the specific technology and specific device form adopted by the network device are not limited in the embodiments of the present disclosure.

Further, the device involved in the present disclosure, which may also be referred to as a terminal device, a user equipment (UE), a mobile station (MS), a mobile terminal (MT), etc., is a device that provides voice and/or data connectivity to a user. For example, the terminal may be a handheld device or a vehicle-mounted device with a wireless connection function. At present, some examples of the terminal are a smart phone, a pocket personal computer (PPC), a palmtop computer, a personal digital assistant (PDA), a notebook computer, a tablet computer, a wearable device, a vehicle-mounted device, or the like. In addition, the terminal device may be vehicle-mounted device when it is used in the vehicle to everything (V2X) communication system. It is to be understood that the specific technology and specific device form adopted by the terminal are not limited in the embodiments of the present disclosure.

FIG. 3 is a flow chart of a method for transmitting a data packet according to an embodiment. As shown in FIG. 3, the method for transmitting the data packet is applied to a first device, and includes the following step.

In S11, the IP data packet is transmitted.

In embodiments of the present disclosure, the IP data packet includes: an identifier of a router for transmitting the IP data packet, and a first time and a second time corresponding to the identifier of the router. The first time and the second time determine a processing time range corresponding to a time at which the router identified by the identifier of the router processes the IP data packet.

In embodiments of the present disclosure, the router processing the IP data packet may be understood as the router, after receiving the IP data packet, parses the IP data packet, determines information included in the IP data packet, and determines the first time and the second time. According to the processing time range determined by the first time and the second time, the information in the IP data packet is processed and then sent to the next-hop router.

In one embodiment, a field corresponding to the first time and a field corresponding to the second time may be introduced to the optional field or a padding field included in the format of the IP data packet shown in FIG. 2. In another embodiment, based on the format shown in FIG. 2, the field corresponding to the first time and the field corresponding to the second time may be introduced to the format shown in FIG. 2 as new fields.

In some embodiments of the present disclosure, the first device is the source device (also referred to as a transmitting device), and the source device determines the IP data packet, and determines the identifier of the router for transmitting the IP data packet and the time range corresponding to the identifier of the router. The IP data packet is transmitted to a router corresponding to a next-hop router address.

The source device may be a network device such as the router or the like, or a terminal such as a computer or the like.

In the method for transmitting the data packet of the present disclosure, the source device determines the identifier of the router for transmitting the IP data packet and the time range corresponding to the identifier of the router, and arranges them in the IP data packet, and the router transmits the IP data packet according to the corresponding time range, which may not only accurately control the time at which the IP data packet reaches the destination device, but also reduce the requirement on the capacity of the router for processing the data packet.

In some embodiments of the present disclosure, the first time is a processing time for the router to process the IP data packet; and the second time is a time error that is allowable for the router to process the IP data packet.

In one embodiment, the first time included in the IP data packet is T, i.e., the processing time for the router to process the IP data packet is T, and the second time is t, i.e., the time error that is allowable for the router to process the IP data packet is t. Then, it is determined according to the first time and the second time that the processing time range corresponding to the time at which the router identified by the identifier of the router processes the IP data packet is from T-t to T+t. For example, the first time is 3 s and the second time is 1 s, and the processing time range corresponding to the time at which the router identified by the identifier of the router processes the IP data packet is determined according to the first time and the second time is from 2s to 4s. That is, the router sends out the data packet after processing the data packet in the range of T-t to T+t (for example, 2s to 4s), thereby reducing the requirement on the capacity of the router for processing the data packet.

In some embodiments of the present disclosure, the first time may be a minimum time allowing the router to process the IP data packet, and the second time may be a maximum time allowing the router to process the IP data packet.

In one embodiment, the first time included in the IP data packet is T1, i.e., the minimum time allowing the router to process the IP data packet is T1, and the second time is T2, i.e., the maximum time allowing the router to process the IP data packet is T2. Then, it is determined according to the first time and the second time that the processing time range corresponding to the time at which the router identified by the identifier of the router processes the IP data packet is from T1 to T2. For example, the first time is 2s and the second time is 4s, and the processing time range corresponding to the time (i.e., the duration) in which the router identified by the identifier of the router processes the IP data packet is determined according to the first time and the second time is from 2s to 4s. That is, the router sends out the data packet after processing the data packet in the range of T1 to T2 (for example, 2s to 4s), thereby reducing the requirement on the capacity of the router for processing the data packet.

In some embodiments of the present disclosure, the identifier of the router is a router address, and the router address is included in the IP data packet in a form of a routing flow table.

FIG. 4 is a flow chart of a method for transmitting a data packet according to an embodiment. As shown in FIG. 4, the method for transmitting the data packet is applied to the first device, and includes the following step.

In S21, the IP data packet is transmitted according to the router address included in the routing flow table.

In embodiments of the present disclosure, the source device determines the IP data packet and transmits the IP data packet to the router corresponding to the router address according to the router address of the routing flow table in the IP data packet.

For example, it is assumed that the flow table includes N router addresses, where N is a positive integer, and there is a correspondence between the router addresses and the routers.

In a case that the first time is the processing time for the router to process the IP data packet, and the second time is the time error that is allowable for the router to process the IP data packet, the IP data packet at least includes the following information: a source address, a destination address, a router address 1, a processing time for a router 1 to process the data packet, a time error allowable for the router 1 to process the data packet, a router address 2, a processing time for a router 2 to process the data packet, a time error allowable for the router 2 to process the data packet, ... a router address N, a processing time for a router N to process the data packet, and a time error allowable for the router N to process the data packet.

In a case that the first time is the processing time for the router to process the IP data packet, and the second time is the time error that is allowable for the router to process the IP data packet, the IP data packet at least includes the following information: a source address, a destination address, a router address 1, a processing time for a router 1 to process the data packet, a time error allowable for the router 1 to process the data packet, a router address 2, a minimum time for a router 2 to process the data packet, a maximum time for the router 2 to process the data packet, ... a router address N, a minimum time for a router N to process the data packet, and a maximum time for the router N to process the data packet.

In the method for transmitting the data packet provided by the embodiments of the present disclosure, after the first device transmits the IP data packet, the data packet is successively transmitted to a next hop, i.e. to a router having a next router address, according to a routing list in the flow table until the data packet is transmitted to the receiving device corresponding to the destination address. For example, in the above-mentioned example, the data packet starts from the source device having the source address, and is transmitted to the router 1 having the router address 1, the router 2 having the router address 2, ... the router N having the router address N successively, and is finally transmitted to the receiving device having the destination address.

In the method for transmitting the data packet provided in the embodiments of the present disclosure, by determining the time at which each router processes the IP data packet, and the allowable error of the processing time, it is possible to determine the precise time the IP data packet arrives at the destination address from the source address, and it is also possible to reduce the burden on every router for processing the IP data packet.

In embodiments of the present disclosure, the IP data packet further includes hop count information.

The hop count information include a hop count. The hop count is a total hop count of routers identified by the identifiers of the routers and a hop count between a router corresponding to a last router address with respect to a destination IP address and the destination IP address where the IP data packet is transmitted to. For example, in a case that the routing flow table includes N router addresses, the hop count for the IP data packet from the source address to the destination address is N+1.

According to the same/similar concept, the embodiments of the present disclosure further provide a method for transmitting a data packet.

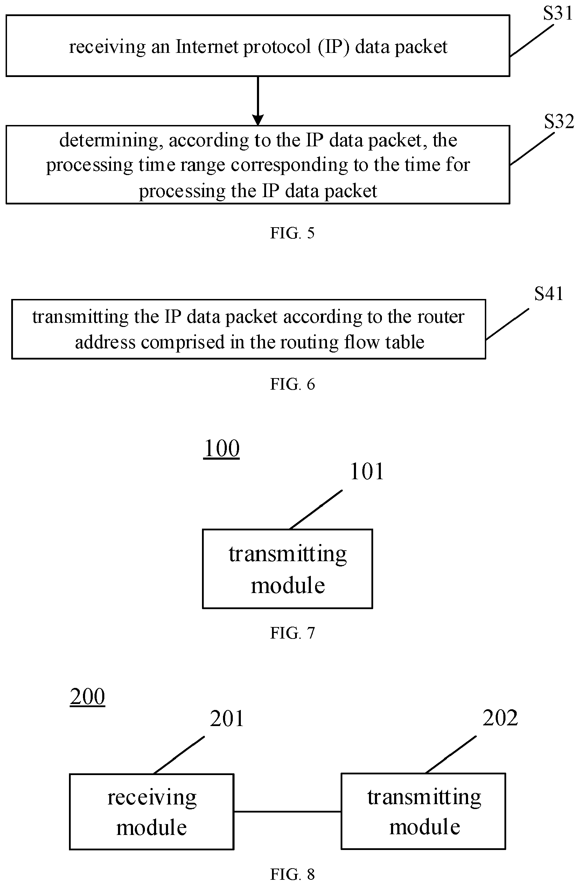

FIG. 5 is a flow chart of a method for transmitting a data packet according to an embodiment. As shown in FIG. 5, the method for transmitting the data packet is applied to a second device, and includes the following steps.

In S31, the IP data packet is received.

In embodiments of the present disclosure, the IP data packet includes: an identifier of a router for transmitting the IP data packet, and a first time and a second time corresponding to the identifier of the router. The first time and the second time determine a processing time range corresponding to a time at which the router identified by the identifier of the router processes the IP data packet.

In some embodiments of the present disclosure, the second device may be the router, and the source device determines the IP data packet, and determines the identifier of the router for transmitting the IP data packet, and the first time and second time corresponding to the identifier of the router. The router receives the IP data packet transmitted by the source device.

In S32, the processing time range corresponding to the time for processing the IP data packet is determined according to the IP data packet.

In embodiments of the present disclosure, the second device determines the first time and the second time corresponding to the second device in the IP data packet according to the received IP data packet, determines the processing time range corresponding to the time for processing the IP data packet according to the first time and the second time, determines to process the IP data packet within the time range, and transmits the IP data packet according to a router address of a next hop after the processing is completed.

In one embodiment, the second device may determine a field corresponding to the first time and a field corresponding to the second time according to the optional field or the padding field included in the format of the IP data packet shown in FIG. 2. In another embodiment, the field corresponding to the first time and the field corresponding to the second time may be determined according to newly added fields to the format shown in FIG. 2.

In the method for transmitting the data packet of the present disclosure, the source device determines the identifier of the router for transmitting the IP data packet and the time range corresponding to the identifier of the router, and arranges them in the IP data packet, and the router transmits the IP data packet according to the corresponding time range, which may not only accurately control the time at which the IP data packet reaches the destination device, but also reduce the requirement on the capacity of the router for processing the data packet.

In some embodiments of the present disclosure, the first time is a processing time for the router to process the IP data packet, and the second time is a time error that is allowable for the router to process the IP data packet.

In one embodiment, the first time included in the IP data packet is T, i.e., the processing time for the router to process the IP data packet is T, and the second time is t, i.e., the time error that is allowable for the router to process the IP data packet is t. Then, it is determined according to the first time and the second time that the processing time range corresponding to the time at which the router identified by the identifier of the router processes the IP data packet is from T-t to T+t. For example, the first time is 3s and the second time is 1 s, the processing time range corresponding to the time at which the router identified by the identifier of the router processes the IP data packet is determined according to the first time and the second time is from 2s to 4s. That is, the router sends out the data packet after processing the data packet in the range of T-t to T+t (for example, 2s to 4s), thereby reducing the requirement on the capacity of the router for processing the data packet.

In some embodiments of the present disclosure, the first time may be a minimum time allowing the router to process the IP data packet, and the second time may be a maximum time allowing the router to process the IP data packet.

In one embodiment, the first time included in the IP data packet is T1, i.e., the minimum time allowing the router to process the IP data packet is T1, and the second time is T2, i.e., the maximum time allowing the router to process the IP data packet is T2. Then, it is determined according to the first time and the second time that the processing time range corresponding to the time at which the router identified by the identifier of the router processes the IP data packet is from T1 to T2. For example, the first time is 2s and the second time is 4s, the processing time range corresponding to the time at which the router identified by the identifier of the router processes the IP data packet is determined according to the first time and the second time is from 2s to 4s. That is, the router sends out the data packet after processing the data packet in the range of T1 to T2 (for example, 2s to 4s), thereby reducing the requirement on the capacity of the router for processing the data packet.

In some embodiments of the present disclosure, the identifier of the router is a router address, and the router address is included in the IP data packet in the form of the routing flow table.

FIG. 6 is a flow chart of a method for transmitting a data packet according to an embodiment. As shown in FIG. 6, the method for transmitting the data packet is applied to the first device, and includes the following step.

In S41, the IP data packet is transmitted according to the router address included in the routing flow table.

In embodiments of the present disclosure, the source device determines the IP data packet. After receiving the IP data packet, the second device transmits the IP data packet to the router corresponding to the router address according to the router address of the routing flow table in the IP data packet.

For example, it is assumed that the flow table includes N router addresses, where N is a positive integer, and there is a correspondence between the router addresses and the routers.

In a case that the first time is the minimum time allowing the router to process the IP data packet, and the second time is the maximum time allowing the router to process the IP data packet, the IP data packet at least includes the following information: a source address, a destination address, a router address 1, a processing time for a router 1 to process the data packet, a time error allowable for the router 1 to process the data packet, a router address 2, a processing time for a router 2 to process the data packet, a time error allowable for the router 2 to process the data packet, ... a router address N, a processing time for a router N to process the data packet, and a time error allowable for the router N to process the data packet.

In a case that the first time is the processing time for the router to process the IP data packet, and the second time is the time error allowable for the router to process the IP data packet, the IP data packet at least includes the following information: a source address, a destination address, a router address 1, a processing time for a router 1 to process the data packet, a time error allowable for the router 1 to process the data packet, a router address 2, a minimum time for a router 2 to process the data packet, a maximum time for the router 2 to process the data packet, ... a router address N, a minimum time for a router N to process the data packet, and a maximum time for the router N to process the data packet.

In the method for transmitting the data packet provided by the embodiments of the present disclosure, after the first device transmits the IP data packet, the data packet is successively transmitted to a next hop, i.e., to a router having a next router address, according to a routing list in the flow table until the data packet is transmitted to the receiving device corresponding to the destination address. For example, in the above-mentioned example, the data packet starts from the source address, and is transmitted to the router 1 having the router address 1, the router 2 having the router address 2, ... the router N having the router address N successively, and is finally transmitted to the receiving device having the destination address.

In the method for transmitting the data packet provided in the embodiments of the present disclosure, by determining the time at which each router processes the IP data packet, and the allowable error of the processing time, it is possible to determine the precise time at which the IP data packet arrives at the destination address from the source address, and it is also possible to reduce the burden on every router for processing the IP data packet.

In embodiments of the present disclosure, the IP data packet further includes hop count information.

The hop count information include a hop count. The hop count is a total hop count of routers identified by the identifiers of the routers and a hop count between a router corresponding to a last router address with respect to a destination IP address and the destination IP address where the IP data packet is transmitted to. For example, in a case that the routing flow table includes N router addresses, the hop count for the IP data packet from the source address to the destination address is N+1.

According to the same concept, embodiments of the present disclosure further provide an apparatus for transmitting a data packet.

It may be understood that, the apparatus provided by the embodiments of the present disclosure includes corresponding hardware structures and/or software modules for performing various functions in order to implement the above-mentioned functions. The embodiments of the present disclosure may be implemented in a form of hardware or a combination of hardware and computer software in combination with units and algorithm steps of each example disclosed in the embodiments of the present disclosure. Whether a function is performed by hardware or by hardware driven by computer software depends on specific applications and design constraints of the technical solution. Those skilled in the art may use different methods to implement the described functions for each specific application, but such an implementation should not be regarded as extending beyond the scope of the technical solutions of the embodiments of the present disclosure.

FIG. 7 is a block diagram illustrating an apparatus for transmitting a data packet according to an embodiment. Referring to FIG. 7, the apparatus 100 includes: a transmitting module 101.

The transmitting module 101 is configured to transmit the IP data packet. The IP data packet includes: an identifier of a router for transmitting the IP data packet, and a first time and a second time corresponding to the identifier of the router. The first time and the second time determine a processing time range corresponding to a time at which the router identified by the identifier of the router processes the IP data packet.

In embodiments of the present disclosure, the first time is a processing time for the router to process the IP data packet; the second time is a time error that is allowable for the router to process the IP data packet; or the first time is a minimum time allowing the router to process the IP data packet, and the second time is a maximum time allowing the router to process the IP data packet.

In embodiments of the present disclosure, the identifier of the router is a router address.

In embodiments of the present disclosure, a plurality of the identifiers of the routers exist and are included in a routing flow table. The transmitting module 101 is further configured to transmit the IP data packet according to the router address included in the routing flow table.

In embodiments of the present disclosure, the IP data packet further includes hop count information. The hop count information includes a hop count, and the hop count is a total hop count of routers identified by the identifiers of the routers and a hop count between a router corresponding to a last router address with respect to a destination IP address and the destination IP address where the IP data packet is transmitted to.

FIG. 8 is a block diagram illustrating an apparatus for transmitting a data packet according to an embodiment. Referring to FIG. 8, the apparatus 200 includes: a receiving module 201.

The receiving module 201 is configured to receive the IP data packet. The IP data packet includes: an identifier of a router for transmitting the IP data packet, and a first time and a second time corresponding to the identifier of the router. The first time and the second time determine a processing time range corresponding to a time at which the router identified by the identifier of the router processes the IP data packet. The processing time range corresponding to the time for processing the IP data packet is determined according to the IP data packet.

In embodiments of the present disclosure, the first time is a processing time for the router to process the IP data packet, and the second time is a time error allowable for the router to process the IP data packet; or the first time is a minimum time allowing the router to process the IP data packet, and the second time is a maximum time allowing the router to process the IP data packet.

In embodiments of the present disclosure, the identifier of the router is a router address.

In embodiments of the present disclosure, a plurality of the identifiers of the routers exist and are included in a routing flow table.

The apparatus for transmitting the data packet further includes: a transmitting module 202.

The transmitting module 202 is configured to transmit the IP data packet according to the router address included in the routing flow table.

In embodiments of the present disclosure, the IP data packet further includes the hop count information.

The hop count information includes the hop count; the hop count is a total hop count of routers identified by the identifiers of the routers and a hop count between a router corresponding to a last router address with respect to a destination IP address and the destination IP address where the IP data packet is transmitted to.

With respect to the apparatuses in the above embodiments, the specific manners for performing operations for individual modules therein have been described in detail in the embodiments regarding the method for transmitting the data packet, which will not be elaborated herein.

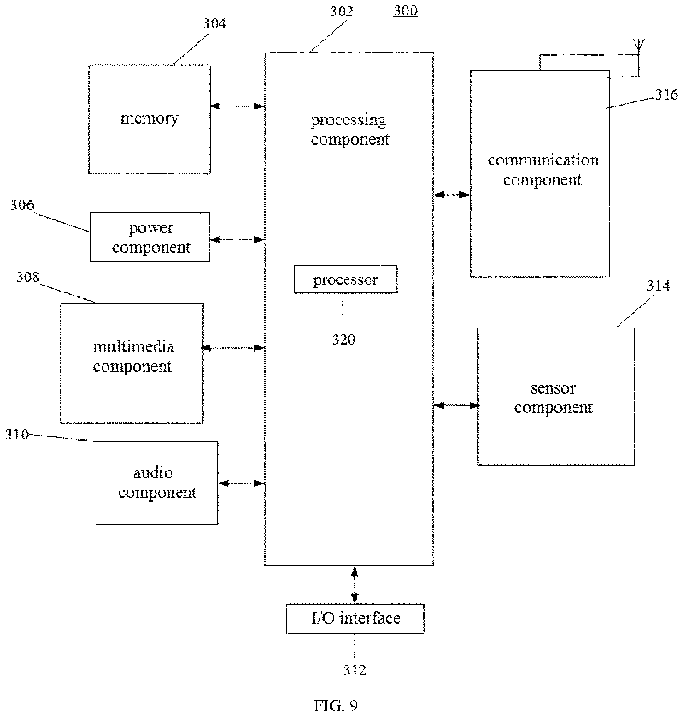

FIG. 9 is a block diagram illustrating a device 300 for transmitting a data packet according to an embodiment. For example, the device 300 can be a mobile phone, a computer, a digital broadcast terminal, a messaging device, a game console, a tablet device, a medical device, a fitness device, a personal digital assistant, or the like.

Referring to FIG. 9, the device 300 may include one or more of the following components: a processing component 302, a memory 304, a power component 306, a multimedia component 308, an audio component 310, an input/output (I/O) interface 312, a sensor component 314, and a communication component 316.

The processing component 302 typically controls overall operations of the device 300, such as the operations associated with display, telephone calls, data communications, camera operations, and recording operations. The processing component 302 may include one or more processors 320 to execute instructions to perform all or part of the steps in the above described methods. Moreover, the processing component 302 may include one or more modules which facilitate the interaction between the processing component 302 and other components. For instance, the processing component 302 may include a multimedia module to facilitate the interaction between the multimedia component 308 and the processing component 302.

The memory 304 is configured to store various types of data to support the operation of the device 300. Examples of such data include instructions for any applications or methods operated on the device 300, contact data, phonebook data, messages, pictures, video, etc. The memory 304 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 306 provides power to various components of the device 300. The power component 306 may include a power management system, one or more power sources, and any other components associated with the generation, management, and distribution of power in the device 300.

The multimedia component 308 includes a screen providing an output interface between the device 300 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 308 includes a front camera and/or a rear camera. The front camera and/or the rear camera may receive an external multimedia datum while the device 300 is in an operation mode, such as a photographing mode or a video mode. Each of the front camera and the rear camera may be a fixed optical lens system or have focus and optical zoom capability.

The audio component 310 is configured to output and/or input audio signals. For example, the audio component 310 includes a microphone (MIC) configured to receive an external audio signal when the device 300 is in an operation mode, such as a call mode, a recording mode, and a voice recognition mode. The received audio signal may be further stored in the memory 304 or transmitted via the communication component 316. In some embodiments, the audio component 310 further includes a speaker to output audio signals.

The I/O interface 312 provides an interface between the processing component 302 and peripheral interface modules, such as a keyboard, a click wheel, a button, and the like. The button may include, but are not limited to, a home button, a volume button, a starting button, and a locking button.

The sensor component 314 includes one or more sensors to provide status assessments of various aspects of the device 300. For instance, the sensor component 314 may detect an open/closed status of the device 300, relative positioning of components, e.g., the display and the keypad, of the device 300, a change in position of the device 300 or a component of the device 300, a presence or absence of user contact with the device 300, an orientation or an acceleration/deceleration of the device 300, and a change in temperature of the device 300. The sensor component 314 may include a proximity sensor configured to detect the presence of nearby objects without any physical contact. The sensor component 314 may include a light sensor, such as a CMOS or CCD image sensor, for use in imaging applications. In some embodiments, the sensor component 314 may include an accelerometer sensor, a gyroscope sensor, a magnetic sensor, a pressure sensor, or a temperature sensor.

The communication component 316 is configured to facilitate communication, wired or wirelessly, between the device 300 and other devices. The device 300 can access a wireless network according to a communication standard, such as WiFi, 2G, or 3G, or a combination thereof. In one embodiment, the communication component 316 receives a broadcast signal or broadcast associated information from an external broadcast management system via a broadcast channel. In one embodiment, the communication component 316 further includes a near field communication (NFC) module to facilitate short-range communications. For example, the NFC module may be implemented according to a radio frequency identifier (RFID) technology, an infrared data association (IrDA) technology, an ultra-wideband (UWB) technology, a Bluetooth (BT) technology, and other technologies.

In embodiments, the device 300 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In embodiments, there is further provided a non-transitory computer-readable storage medium (such as the memory 304) including instructions that, when executed by the processor 320 of the device 300, to perform any of the above-described methods. For example, the non-transitory computer-readable storage medium may be a ROM, a RAM, a CD-ROM, a magnetic tape, a floppy disc, an optical data storage device, and the like.

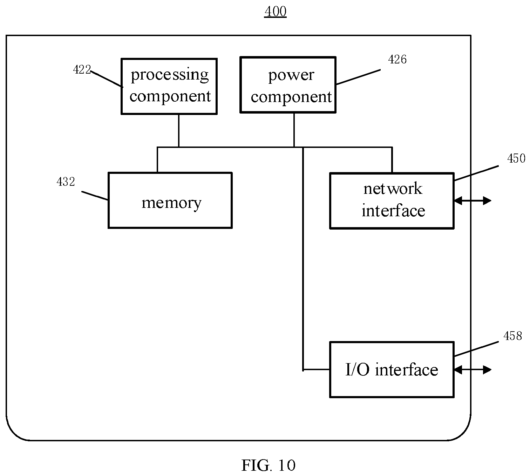

FIG. 10 is a block diagram illustrating a device 400 for transmitting a data packet according to an embodiment. For example, the device 400 may be a server. Referring to FIG. 10, the device 400 includes a processing component 422 including one or more processors, and a memory resource represented by a memory 432. The memory resource is configured to store instructions executable by the processing component 422, such as application programs. The application program stored in the memory 432 may include one or more modules corresponding to a set of instructions. In addition, the processing component 422 is configured to execute the instructions to perform the above method.

The device 400 further includes a power component 426 configured to operate a power management of the device 400, a wired or wireless network interface 450 configured to connect the device 400 to the network, and an input/output (I/O) interface 458. The device 400 may operate according to an operating system stored in the memory 432, such as Windows Server TM, Mac OS XTM, Unix TM, Linux TM, Free BSDTM, or the like.

It is further understood that "a plurality" in this disclosure refers to two or more, and other quantifiers are similar thereto. Term "and/or", which describes an associated relationship of associated objects, refers to three relationships. For example, A and/or B means that A exists alone, A and B exist at the same time, and B exists alone. Character "j" generally indicates that contextual objects are in an "or" relationship. Terms "a/an" and "the" in the singular form are intended to include plural forms, unless clearly indicated in the context otherwise.

It is further understood that terms such as "first", and "second" are used to describe various information, these information should not be limited by these terms. These terms are only used for distinguishing information of the same type from each other and do not denote a particular order or degree of importance. As a matter of fact, the terms such as "first", and "second" may be used interchangeably. For example, without departing from the scope of embodiments of the present disclosure, first information may also be referred to as second information, and similarly, the second information may also be referred to as the first information.

It is further understood that although operations are described in a specific order in the accompanying drawings in the embodiments of the present disclosure, it should not be understood that these operations are required to be performed in the specific order shown or in a serial order, or that all of the operations shown are required to be performed to obtain desired results. In some circumstances, multitasking and parallel processing may be advantageous.

Other embodiments of the present disclosure will be apparent to those skilled in the art from consideration of the specification and practice of the present disclosure disclosed here. The present disclosure is intended to cover any variations, uses, or adaptations of the present disclosure following the general principles thereof and including such departures from the present disclosure as come within known or customary practice in the art. It is intended that the specification and examples be considered as explanatory only, with a true scope and spirit of the present disclosure being indicated by the following claims.

It will be appreciated that the present disclosure is not limited to the exact construction that has been described above and illustrated in the accompanying drawings, and that various modifications and changes can be made without departing from the scope thereof. It is intended that the scope of the present disclosure only be limited by the appended claims.

## Claims

1. A method for transmitting a data packet, applied to a first device, comprising:
transmitting an Internet protocol, IP, data packet, wherein the IP data packet comprises: an identifier of a router for transmitting the IP data packet, and a first time and a second time corresponding to the identifier of the router, and the first time and the second time determine a processing time range corresponding to a time at which the router identified by the identifier of the router processes the IP data packet.

2. The method according to claim 1, wherein the first time is a processing time for the router to process the IP data packet, and the second time is a time error that is allowable for the router to process the IP data packet;
or
wherein the first time is a minimum time allowing the router to process the IP data packet, and the second time is a maximum time allowing the router to process the IP data packet.

3. The method according to claim 1 or 2, wherein the identifier of the router is a router address.

4. The method according to claim 3, wherein a plurality of identifiers of routers exist and are comprised in a routing flow table; and
wherein the method for transmitting the data packet further comprises:
transmitting the IP data packet according to the router address comprised in the routing flow table.

5. The method according to claim 1, wherein the IP data packet further comprises hop count information; and
wherein the hop count information comprises a hop count, the hop count is a total hop count of routers identified by the identifiers of the routers and a hop count between a router corresponding to a last router address with respect to a destination IP address and the destination IP address where the IP data packet is transmitted to.

6. A method for transmitting a data packet, applied to a second device, comprising:
receiving an IP data packet, wherein the IP data packet comprises: an identifier of a router for transmitting the IP data packet, and a first time and a second time corresponding to the identifier of the router, and the first time and the second time determine a processing time range corresponding to a time at which the router identified by the identifier of the router processes the IP data packet; and
determining, according to the IP data packet, the processing time range corresponding to the time for processing the IP data packet.

7. The method according to claim 6, wherein the first time is a processing time for the router to process the IP data packet, and the second time is a time error that is allowable for the router to process the IP data packet;
or
the first time is a minimum time allowing the router to process the IP data packet, and the second time is a maximum time allowing the router to process the IP data packet.

8. The method according to claim 6 or 7, wherein the identifier of the router is a router address.

9. The method according to claim 6, wherein a plurality of identifiers of routers exist and are comprised in a routing flow table; and
wherein the method for transmitting the data packet further comprises:
transmitting the IP data packet according to the router address comprised in the routing flow table.

10. The method according to claim 6, wherein the IP data packet further comprises hop count information; and
wherein the hop count information comprises a hop count, the hop count is a total hop count of routers identified by the identifiers of the routers and a hop count between a router corresponding to a last router address with respect to a destination IP address and the destination IP address where the IP data packet is transmitted to.

11. An apparatus for transmitting a data packet, applied to a first device, comprising:
a transmitting module configured to transmit an IP data packet,
wherein the IP data packet comprises: an identifier of a router for transmitting the IP data packet, and a first time and a second time corresponding to the identifier of the router, and the first time and the second time determine a processing time range corresponding to a time at which the router identified by the identifier of the router processes the IP data packet.

12. The apparatus according to claim 11, wherein the first time is a processing time for the router to process the IP data packet, and the second time is a time error that is allowable for the router to process the IP data packet;
or
wherein the first time is a minimum time allowing the router to process the IP data packet, and the second time is a maximum time allowing the router to process the IP data packet.

13. The apparatus according to claim 11, wherein a plurality of identifiers of routers exist and are comprised in a routing flow table; and
wherein the transmitting module is further configured to:
transmit the IP data packet according to the router address comprised in the routing flow table.

14. An apparatus for transmitting a data packet, applied to a second device, comprising:
a receiving module configured to:
receive an IP data packet, wherein the IP data packet comprises: an identifier of a router for transmitting the IP data packet, and a first time and a second time corresponding to the identifier of the router, and the first time and the second time determine a processing time range corresponding to a time at which the router identified by the identifier of the router processes the IP data packet; and
determine, according to the IP data packet, the processing time range corresponding to the time for processing the IP data packet.

15. The apparatus according to claim 14, wherein the first time is a processing time for the router to process the IP data packet; the second time is a time error that is allowable for the router to process the IP data packet;
or
wherein the first time is a minimum time allowing the router to process the IP data packet, and the second time is a maximum time allowing the router to process the IP data packet.

16. The apparatus according to claim 14, wherein a plurality of identifiers of routers exist and are comprised in a routing flow table; and
wherein the apparatus for transmitting the data packet further comprises: a transmitting module configured to transmit the IP data packet according to the router address comprised in the routing flow table.

17. A device for transmitting a data packet, comprising:
a processor; and
a memory for storing processor-executable instructions;
wherein the processor is configured to perform the method for transmitting the data packet according to any one of claims 1 to 5, or perform the method for transmitting the data packet according to any one of claims 6 to 10.

18. A non-transitory computer readable storage medium having instructions that, when executed by a processor of a mobile terminal, cause the mobile terminal to perform the method for transmitting the data packet according to any one of claims 1 to 5 or perform the method for transmitting the data packet according to any one of claims 6 to 10.
